(19) Europäisches Patentamt

European Patent Office

Office européen des brevets

(11) **EP 1 659 093 A2**

(12) **EUROPEAN PATENT APPLICATION**

(43) Date of publication:
24.05.2006 Bulletin 2006/21

(51) Int Cl.:
***B81C 1/00*** (2006.01)

(21) Application number: **05257224.5**

(22) Date of filing: **23.11.2005**

(84) Designated Contracting States:
**AT BE BG CH CY CZ DE DK EE ES FI FR GB GR HU IE IS IT LI LT LU LV MC NL PL PT RO SE SI SK TR**
Designated Extension States:
**AL BA HR MK YU**

(30) Priority: **23.11.2004 US 997222**

(71) Applicant: **Hewlett-Packard Development Company, L.P.**
**Houston, TX 77070 (US)**

(72) Inventors:
• **Ching, Kiong Chin**
**Singapore 467508 (SG)**

• **Chia, Wai Tuck**
**Singapore 109673 (SG)**
• **Tan, Kee Cheong**
**Singapore 266467 (SG)**
• **Zhu, Lei**
**12-36, Singapore 120111 (SG)**

(74) Representative: **Powell, Stephen David et al**
**Williams Powell,**
**Morley House**
**26-30 Holborn Viaduct**
**London EC1A 2BP (GB)**

(54) **Method of manufacturing a microstructure**

(57)    In a method of manufacturing a microstructure that requires a first material (6) and a second material (8) attached together and a laser system for producing a laser beam, the first material exhibiting an ablation threshold that does not exceed a predetermined ablation fluence of the laser beam and the second material exhibiting a second ablation threshold that exceeds the predetermined ablation fluence, a removal process comprises removing (16) a portion of the first material to leave a remnant thereof at an interface of the two materials and then, ablating (24) the remnant material using the laser beam at the predetermined ablation fluence to remove the remnant material. The process of selecting the first of the two materials is based on the predetermined ablation fluence of the laser beam, and the selection of a laser system is based on the respective ablation thresholds of the first and second materials.

Figure 1A

**EP 1 659 093 A2**

**Description**

The present invention generally relates to a method of manufacturing a microstructure, and more particularly, a polymer on silicon microstructure.

Micro electromechanical systems (MEMSs), which are the integration of mechanical elements, sensors, actuators, and electronics on a common silicon substrate through microfabrication technology, is gaining popularity in applications such as biotechnology and communications. In the manufacturing of each MEMS device, the electronics are fabricated using integrated circuits processing sequences (e.g., CMOS, Bipolar, or BICMOS processes) while the micromechanical components are fabricated using compatible micromaching processes that selectively remove or etch away parts of a silicon wafer or add new structural layers to form the mechanical and electromechanical devices.

In the biotechnology field, MEMS technology is used in applications such as the polymerase chain reaction (PCR) microsystems for DNA amplification and identification, micromachined scanning tunneling microscopes (STMs), biochips for detection of hazardous chemical and biological agents, and microsystems for high-throughput drug screening and selection.

In the communications field, electrical components such as inductors and tunable capacitors can be integrated into a single circuit. With the integration of such components, the performance of communication circuits improves, while the total circuit area, power consumption and cost are reduced. In addition, the mechanical switch is a key component in various microwave circuits. Demonstrated samples of mechanical switches have quality factors much higher than those previously available.

It is common for some of the MEMS devices to include a polymer on silicon microstructure. One known technique for microfabricating such a microstructure involves laser ablation to form kerfs and blind vias in the microstructure. As it is sometimes only necessary to ablate the silicon and not the polymer, the laser ablation has to be precisely controlled. One such laser ablation method is to empirically obtain a count of the number of laser pulses (of a particular laser beam) required for ablating a given amount or depth of material and using this number of pulses to subsequently ablate similar structures. The throughput of such an open-loop ablation method is low and often results in either undercutting of silicon or overcutting of the polymer. Another laser ablation method includes depth feedback control. This method however also suffers from low throughput. Thus, it is desirable to have a method of micromachining a polymer-silicon microstructure that is relatively more effective and accurate.

The method of laser micromachining a "polymer-on-silicon" microstructure is associated with at least two disadvantages. Firstly, it gives rise to an inaccurate etching depth per laser pulse or per unit time and thus increases the chances of affecting the under-layer. Secondly, the heat generated from the micromachining lasers is likely to affect the devices embedded within the silicon microstructures.

In one aspect of the present invention a method for manufacturing a microstructure is provided. The method includes providing a first material, a second material attached to the first material and a laser system for producing a laser beam. The first material provided exhibits a first ablation threshold that does not exceed a predetermined ablation fluence of the laser beam and the second material provided exhibits a second ablation threshold that exceeds the predetermined ablation fluence of the laser beam. The method further includes the removal of a portion of the first material to leave a remnant thereof at an interface of the two materials and thereafter to ablate the remnant material using the laser beam at the predetermined ablation fluence to remove the remnant material.

The invention will be better understood with reference to the drawings, in which:

Figure 1A is flowchart of a sequence of steps, according to an embodiment of the invention, for manufacturing a microstructure.

Figure 1B is a schematic drawing illustrating a polymer-on-silicon microstructure of a MEMS device with a first material Polyimide attached to the second material, Silicon (Si), which also functions as the substrate in accordance with an embodiment of the present invention.

Figure 2A is a schematic drawing showing a microstructure wherein a first laser beam is used to ablate a portion of the first material in the bulk material removing step in Figure 1;

Figure 2B is a schematic drawing showing the microstructure in Figure 2A wherein a second laser beam is irradiated onto the remnant first material from the same side as the first material to remove the remnant first material;

Figure 2C is a schematic drawing showing the microstructure in Figure 2A wherein a second laser beam is irradiated through the second material onto the remnant first material, according to an alternative embodiment, to remove the remnant first material; and

Figures 3A, 3B and 3C are schematic drawings similar to those in Figures 2A, 2B and 2C respectively, wherein the microstructure further includes a circuit layer sandwiched between the first and the second material to define a microdevice.

Figure 4 is a flowchart detailing a method including a sequence of steps in which each step is to be executed for selecting the materials and laser for the ablation process.

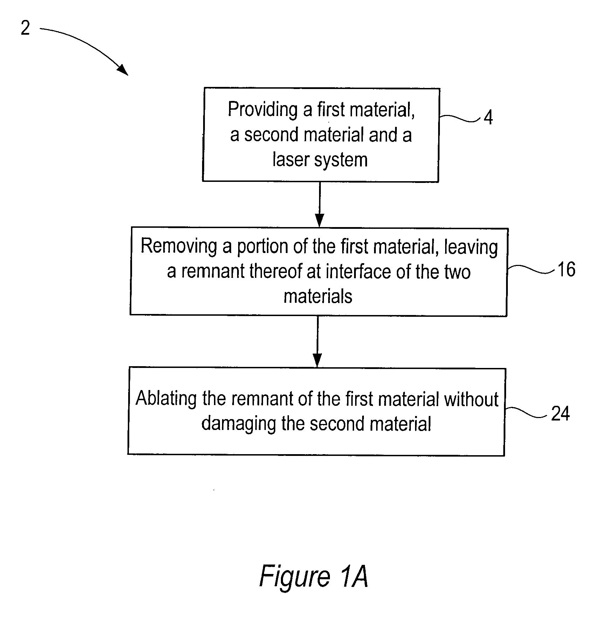

The flowchart of Figure 1A illustrates a method 2 for manufacturing a microstructure. A first step 4 includes providing at 4 a first material, a second material and a laser system. A second step 16 includes removing a portion of the first material leaving a remnant thereof at the interface of the two materials. A final step 24 involves ablating the remnant of the first material without damaging the second material.

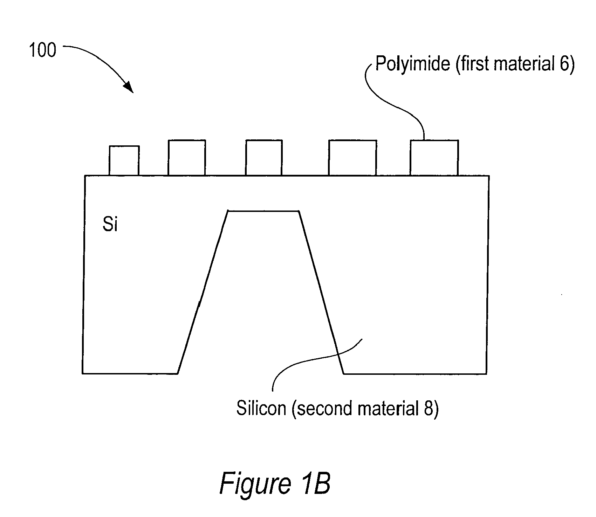

An example of such a microstructure is a polymer-on-silicon microstructure 100 of a MEMS device as shown in Figure 1 B. In the polymer-on-silicon microstructure 100, Silicon (Si) may act as the second material 8 as well as the substrate on which Polyimide, the first material 6, is attached. A polymer-on-silicon microstructure 100 may be in any MEMS device.

For example, a polymer-on-silicon microstructure 100 may be present in high aspect ratio silicon strips used as waveguide core with low absorption characteristics, in which each through etched silicon strip is 4um wide, 105um high and 8mm long. A polymer-on-silicon microstructure 100 may also be used in many other areas such as in inkjet print heads, or in micro-medical devices for the dispensation of fluids. The channels of the above microstructure devices can be in micrometers, or smaller depending on the type of laser and its optics being used.

When irradiated with the laser beam 10 set at a predetermined ablation fluence, the first material 6 exhibits a first ablation threshold that does not exceed the predetermined ablation fluence and the second material 8 exhibits a second ablation threshold that exceeds the predetermined ablation fluence. In this manner, the laser beam 10 when irradiated onto the first material 6 to produce the predetermined ablation fluence on a surface thereof can be used to ablate the first material 6 without substantially removing or damaging the second material 8. In other words, the ablation of the microstructure 5, for example to create a kerf or blind via 12 of a diameter of around 10 microns in the first material 6, is self-limiting. The second material is able to act as an "etch stop".

In one embodiment, any commercial nanosecond (ns) laser with a wavelength range from 400nm to 800nm can be used. Examples of such lasers are the Q-switched Nd:YAG laser with an output laser beam having a wavelength of 532nm, Nd:YLF laser with pulsewidth of 8ns and wavelength of 526nm and Cr:LiSAF laser with pulsewidth of 80ns and wavelength of 855nm but are not limited to these. With a laser, that utilizes the above-mentioned wavelength and pulse width ranges, the ablation thresholds of some polymers such as polyimide, polymethylmethacrylate and polytetrafluoroethylene, for example, are much higher than that of silicon that is about $0.42J/cm^2$. (Applied Surface Science 207(2003) 306-313). The ablation threshold may be selected such that the second ablation threshold is at least twice the first ablation threshold.

The method 2 further includes removing 16 a portion of the first material 6, for example to create a blind via 12, to leave a remnant 18 of the first material 6 adjacent an interface 20 of the two materials 6, 8. The portion of the first material 6 may be removed using any bulk micromachining technique. Bulk micromachining techniques include but are not limited to etching, micro milling, micro drilling, reactive ion etching (RIE), deep RIE (DRIE) and excimer laser machining.

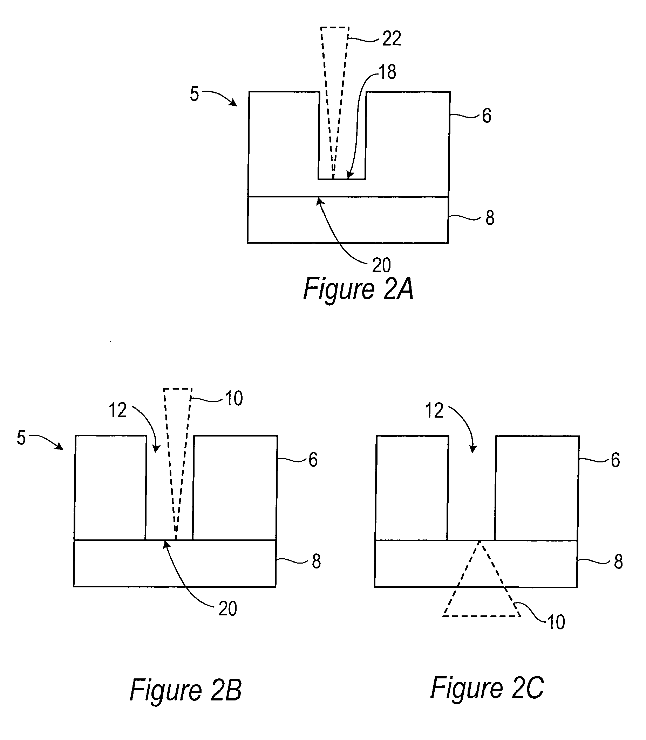

Bulk micromachining allows the portion of the first material 6 to be removed relatively quickly. Figure 2A shows an excimer laser beam 22 being used to ablate the portion of the first material 6. When using excimer laser machining for removing the portion of the first material 6, a predetermined number of laser pulses may be irradiated so that the excimer laser beam 22 removes a corresponding amount of the first material 6. Examples of such laser systems may be the excimer laser system series 8000 (Exitech UK) equipped with a Lambda Physik laser, EX Series (GAM Lasers Inc.) and Maestro Series (Resonetics Laser Systems Group) can be used but are not limited to this.

The method 2 further includes ablating 24 the remnant material 18 using the laser beam 10 at the predetermined ablation fluence to remove the remnant material 18 without substantially removing the second material 8. Since the ablation fluence of the laser beam 10 is lower than the second ablation threshold, irradiating the laser beam onto the second material 8 does not result in any substantial ablation of the second material 8. The remnant material 18 may be removed by irradiating the laser beam 10 onto the remnant material 18 from the same side as the first material 6 as shown in Figure 2B. Ablation of the remnant material 18 with such a positioning of the laser beam 10 may produce a plume (not shown) adjacent the remnant material 18.

The plume is a plasma-like substance consisting of molecular fragments, neutral particles, free electrons and ions, and chemical reaction products. The plume results in optical absorption and scattering of the incident laser beam 10 and can condense on the surrounding material 6 and/or the beam delivery optics (not shown) of the laser system. If the laser beam 10 is adversely affected, the ablation site may be cleared by a pressurized inert gas, such as nitrogen or argon.

To avoid problems associated with the plume, the remnant material 18 may be removed by irradiating the laser beam 10 through the second material 8 onto the remnant material 18 as shown in Figure 2C. In this manner, the laser beam 10 is unlikely to be affected by the plume. A short focal length laser beam 10 is focused through the second material 8 onto the first material 6 such that the predetermined ablation fluence is attained at a focal point or spot of the beam 10. The effect of such a short focal length laser beam 10 on the second material 8 is minimized.

Lasers with wavelengths ranging from 400nm up to 1 um are suitable for the removal of the remnant material 18 at the interface by irradiating the laser beam 10 through the second material 8 because the polymer in question is transparent in the spectral range and it has much higher ablation threshold than silicon. A Q-switched Nd:YAG laser system with an output of 532nm/1.06um would be sufficient for this purpose but is not limited to this laser. Alternatively, a femto second laser system with an output in the same wavelength range can also be used since the polymer would have an ablation threshold approximately five times that of silicon. An example of such a system would be a Ti:sapphire laser system with a pulsewidth of 150fs and a wavelength of 800nm but is not limited to this. The absorption of two photons by the polymer subjected to femto second laser irradiation has to be taken into consideration especially at the interface between the first material 6 and the second material 8 when a short focal lens is used. Therefore, the laser used in Figure 2B may be a femto second laser or a ns laser with its wavelength chosen to be transparent to the second material 8.The laser used in Figure 2C may be a ns laser or femto second laser with its corresponding wavelength also chosen to be transparent to the second material 8.

One of the first material 6, the second material 8 and the laser system may be used as a basis for the selection of the other components In some embodiments, the first material 6 and the second material 8 may be attached together. Attaching means may include but are not limited to gluing, spin coating, sputter coating, laser welding to, thermal curing or chemical bonding.

In providing the components, the laser system may be the starting point; In addition, the first 6 and the second material 8 are selected based on a predetermined ablation fluence of the laser beam that is to be used to ablate the first material 6. The laser system may include either a continuous wave (CW) or a pulsed laser.

In selecting a material 6 for use with the laser, the ability of the material 6, 8 to absorb the laser energy is considered. The absorption of laser energy limits the depth to which that energy can perform useful ablation in the material 6. The absorption depth of the material 6 determines ablation depth and the heat of vaporization of the material 6 caused by ablation. The absorption depth is also a function of the laser wavelength, the beam energy density and the laser pulse duration (for a pulsed laser or, less commonly, a CW laser which is shuttered). The laser beam energy density or energy per unit area on the material 6, 8 is measured in terms of the energy fluence defined as follows:

$$\text{Fluence (Joules/cm}^2) = \text{laser pulse energy (J) / focal spot area (cm}^2)$$

It should be noted that laser ablation results in a heat affected zone in the ablated material 6. This heat affected zone is formed by molten material 6 that re-solidifies in situ or formed by material 6 that was sufficiently heated and cooled rapidly enough to result in embrittlement. This change in material properties can alter subsequent laser ablation and material performance.

The size of the heat-affected zone is a function of the laser pulse duration and the material parameters such as thermal conductivity and specific heat. The extent of the heat-affected zone depends on the distance the heat is conducted within the material 6 and varies with material 6 and the laser wavelength. The better the material conduction (thermal diffusivity) the greater is the extent of the heat-affected zone. The effect of the heat-affected zone on the material 6 (embrittlement, for example) is more a function of the material thermomechanical properties.

Associated with the heat-affected zone is recast and formation of burrs. During ablation, the expulsion of material 6 creates a compressive force on the molten pool of material 6 under the spot of the laser beam 10. This causes a portion of the liquefied material 6 to be forced out of the ablation zone to be deposited onto the surrounding region. The amount of recast material can be minimized by selecting a material 6 of a small absorption depth that reduces the melted volume and by using a high laser power that converts more of the melted material into vapor faster. Higher power may be obtained with a laser of a shorter pulse duration. Such a laser has a reduced dynamic impact on the relatively massive liquefied material 6. The duration of the forcing function is small compared to the dynamic response time of the liquefied material 6. The second material 8 should be selected such that it is transparent in the wavelength region of the laser beam 10.

The second material is considered transparent when more then 80% transmission occurs during one photon transmission. For example, quartz is measured to have more than 80% transmission in the spectral range from 300 nm to 1um and is therefore, considered to be transparent. Similarly, the polymer used is considered transparent in the spectral range of 400nm to 1 um as it has at least 80% transmission in the said spectral range as well. Hence, the transparency of a material is only associated with the wavelength.

If however the first and the second materials 6, 8 are used as the starting point of selection of the components, the laser system, or more particularly the parameters of a laser beam 10 of the laser system, are selected such that when irradiated therewith the first material 6 exhibits a first ablation threshold or fluence that does not exceed a predetermined ablation fluence of the laser beam 10 and the second material 8 exhibits a second ablation threshold or fluence that exceeds the predetermined ablation fluence as described above. Several laser parameters, as discussed above, need to be similarly considered when selecting the laser.

The first parameter is the selection of a wavelength that results in a minimum absorption depth of the first material 6 to be ablated. This helps ensure a high-energy deposition in a small volume of the first material 6 for rapid and complete ablation thereof. The second parameter is the pulse duration for maximizing peak power and minimizing thermal conduction to the surrounding material 6. The third parameter is the pulse repetition rate. If the rate is too low, all of the energy that is not used for ablation dissipates from the ablation zone to allow cooling of the ablation zone in the first material 6. If the pulse repetition rate is high, the heat generated can be better retained and consequently, the ablation is more efficient. With a high pulse repetition rate, more of the incident energy goes toward ablation and less is lost to the surrounding material and the environment. The fourth parameter is the beam quality.

Beam quality is measured by the brightness (energy), the focusability, and the homogeneity of the beam. The beam energy is of little or no use if it cannot be properly and efficiently channeled to the ablation zone. Further, if the beam is not of a controllable size, the ablation region may be larger than desired resulting in for example an excessive slope in the sidewalls when ablating the blind via 12.

It is found that selecting a laser that has a relatively low duty cycle is advantageous for ablation. That is, the pulse width (time) is short compared to the time between pulses. Therefore, even though such a laser has a low average power compared to other lasers of higher duty cycles, the peak power of the laser can be quite large. The peak power and peak intensity of the laser are given by:

$$\text{Peak power (W) = pulse energy (J) / pulse duration (sec)}$$

$$\text{Irradiance or Intensity (Watts/cm}^2\text{) = peak power (W) / focal spot area (cm}^2\text{)}$$

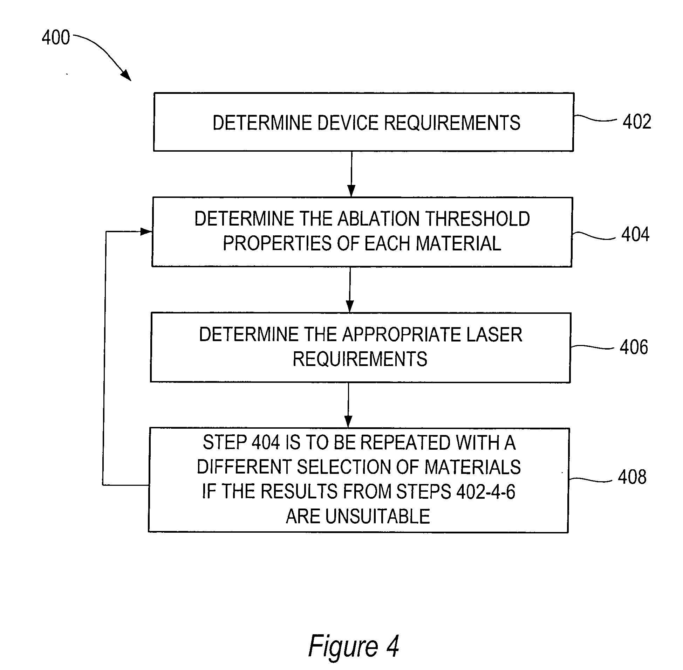

The method 400 including the following sequence of steps, as shown in Figure 4, may be used to select the materials and laser for the ablation process. A first step 402 involves determining the device parameters. It is to be determined, for example, how many layers, what type of layers and what is the thickness of the layers that the microstructure includes. A next step 404 involves determining the ablation threshold properties of each material. A next step 406 involves determining the most appropriate laser parameters. A final step 408 includes repeating step 404 with different materials if Steps 402-406 do not provide suitable results. If necessary, more than one iteration may be needed to make a selection.

The laser may be, for example in one embodiment, a Q-switched laser, which is a modification of a pulsed laser to reduce its output pulse width in order to boost its peak output power, and to improve the consistency of the output from pulse to pulse. Peak optical output power of such a Q-switched laser can be much greater than one without Q-switching. Due to the short pulse duration, typically in nanoseconds or picoseconds (or even less), peak power of megawatts or gigawatts may be produced by even modest size lasers. Q-switched lasers are very often solid state optically pumped types (e.g., Nd:YAG, ruby, etc.) but this technique can be applied to many other (but not all) lasers as well.

In yet another embodiment, the laser may also be an ultra-short pulse laser, which refers to any laser with pulse durations in the femtosecond range (1 femtosecond = $1*10^{-15}$ seconds). Ultrashort pulses are generally considered to be 1 picosecond or shorter, typically shorter than 300 femto-seconds. As a comparison, a Q-switched Nd:YAG pulse is generally around 20 nanoseconds, i.e. about $10^6$ times longer than that of a 100- femtosecond ultra-short pulse laser.

Alternatively, the pulse width of a Nd:YAG can be changed to turn it into an ultrashort pulse laser by utilizing different technologies. For example, Nd:YAG can be a nanosecond output by Q-switching technique, or pico second or sub-pico second output by active/passive mode-locking technique.

It should be noted that materials react quite differently at femtosecond time scales than at longer ones. When ablating semiconductors with an ultra-short pulse laser, the electrons in the semiconductors do not have time to transfer heat to the lattice, i.e., processing is essentially athermal. The semiconductor material in the ablation zone is removed without transferring significant amount of heat to the rest of the semiconductor material adjacent to the ablation zone. Ultrashort-pulse lasers are consequently ideal material removal tools. It is found that in metals such as silicon, a 1,000 times reduction of pulse duration reduces the heat-affected zone by a factor of only 10. If metal is processed with nanosecond pulses, a 1-micron heat-affected zone can be obtained. With femtosecond pulses, a 0.1-micron heat-affected zone can be obtained.

An example of an ultrashort pulse laser is a mode-locked laser. A mode-locked laser operates because of the resonant modes of an optical cavity that affects the characteristics of the output beam. When the phases of different frequency modes are synchronized, i.e., "locked together," the different modes interfere with one another to generate a beat effect. The result is a laser output, which is observed as regularly spaced pulsations. Lasers operating in this mode-locked fashion, usually produce a train of regularly spaced pulses, each having duration of $10^{-15}$ (femto) to $10^{-12}$ (pico) seconds. A mode-locked laser can deliver extremely high peak powers than the same laser operating in the Q-switched mode. These pulses have enormous peak powers often in the range from $10^{12}$ Watts peak.

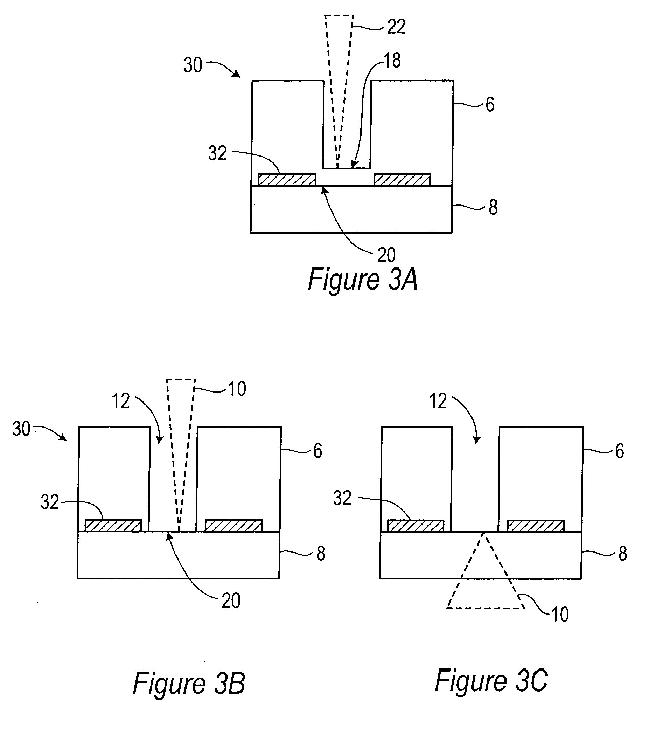

An advantage of using ultrashort laser pulses is that it makes it easier to reach high peak powers while at relatively low energies. 100 mJ in 100 fs gives an average pulse power of 1 Terawatt (1 TW = $10^{12}$ watts). Using a 1 ns pulse would require 1,000 J of energy to reach the same average power, and would generally cost much more money to build and operate such a laser. The pulse width of an ultrashort pulse laser is short enough to greatly reduce the transfer of heat out of the ablation zone. This tends to localize the heat more and reduces the extent of the heat-affected zone. Consequently, the ultra short pulse laser may be used to ablate a microdevice 30 which is essentially a microstructure that includes a circuit layer 32 sandwiched between a first material 6 and a second material 8 as shown in Figures 3A-3C, with high accuracy or good selectivity, so as to avoid damaging the circuit layer 32.

In one embodiment, the first material 6 may be a semiconductor material, such as silicon, while the second material 8 may be any polymeric material, such as SU8, PMMA and polyimide. For the combination of Si/Polymer to make microvalve devices, a ns laser with wavelength ranging from 400nm to 800nm may be used, for example, 20ns Nd:YAG laser with output of 532nm. Alternatively a femto laser in the same spectral range can also be used, for instance Ti:sapphire laser system (150fs and 800nm). When a Q-switched Nd:YAG laser at 532nm is used, the ablation fluence should be tuned to the level of 0.5J/cm2 while the polymer has nominal absorption or damage to this wavelength. When a fs laser with 150fs pulsewidth and 800nm wavelength is used, the irradiating fluence has to be around 0.2 to 0.5 J/cm2 such that it would not exceed the ablation threshold of polymer that is around 1.0 to 2.6J/cm2.

The selected parameters allow the laser beam to have an ablation fluence of about 0.2 - 0.5 J/cm$^2$. When irradiated with such a laser beam, the silicon exhibits an ablation threshold of about 0.2 J/cm$^2$, while polyimide, SU8 and PMMA exhibit an ablation threshold of 1.0, 1.1 and 2.6 J/cm$^2$ respectively.

Advantageously, the method 2 that embodies the invention allows quick and precise micromachining of microstructures. The method is quick because the removal of the portion of the first material may proceed at a high speed without the concern of damaging the second material or the need for precise control of the cutting depth or profile. A remnant first material left at the interface of the first and the second material is subsequently removed using a self-limiting and thus more precise laser ablation step. Consequently, the overall throughput of manufacturing of the microstructure is increased compared to that in the prior art.

**Claims**

1. A method of manufacturing a microstructure comprising:

   providing a first material, a second material attached to the first material, and a laser system for producing a laser beam, wherein the first material exhibits a first ablation threshold that does not exceed a predetermined ablation fluence of the laser beam and the second material exhibits a second ablation threshold that exceeds the predetermined ablation fluence;

   removing a portion of the first material to leave a remnant thereof at an interface of the two materials; and

   ablating the remnant material using the laser beam at the predetermined ablation fluence to remove the remnant material.

2. A method according to Claim 1, wherein providing a first material, a second material and a laser system comprises one of:

   selecting a first material and a second material based on the predetermined ablation fluence of the laser beam; and

   selecting a laser system based on the first and the second material.

3. A method according to Claim 2, further comprising attaching the first and the second materials together.

4. A method according to Claim 1, wherein the first material comprises a semiconductor material and the second material comprises a polymeric material.

5. A method according to Claim 4, wherein the polymeric material comprises one of SU8, polyimide and PMMA.

6. A method according to Claim 1, wherein removing a portion of the first material comprises removing the portion using a bulk micromachining technique.

7. A method according to Claim 6, wherein the bulk micromachining technique comprises one of etching, micro milling, micro drilling and excimer laser machining.

8. A method according to Claim 1, wherein the laser beam comprises an ultra-short pulsed laser beam.

9. A method according to Claim 8, wherein the ultra-short pulsed laser beam comprises a pulsed laser beam wherein each pulse has a pulse width of less than 1 pico-second duration.

10. A method according to Claim 9, wherein each pulse has a pulse width of less than 300 femto-second duration.

11. A method according to Claim 1, wherein the second ablation threshold is at least twice the first ablation threshold.

12. A method according to Claim 1, wherein the laser beam is irradiated onto the remnant material from the same side as the first material.

13. A method according to Claim 1, wherein the laser beam is irradiated through the second material onto the remnant material.

2

```
┌─────────────────────────────┐
│   Providing a first material, │
│   a second material and a     │──── 4
│        laser system           │
└─────────────────────────────┘
                │
                ▼
┌─────────────────────────────────┐
│ Removing a portion of the first material, leaving │
│  a remnant thereof at interface of the two      │──── 16
│              materials             │
└─────────────────────────────────┘
                │
                ▼
┌─────────────────────────────────┐
│ Ablating the remnant of the first material without │
│      damaging the second material      │──── 24
└─────────────────────────────────┘
```

*Figure 1A*

100

Polyimide (first material 6)

Si

Silicon (second material 8)

*Figure 1B*

Figure 2A

Figure 2B

Figure 2C

*Figure 3A*

*Figure 3B*                    *Figure 3C*

400

DETERMINE DEVICE REQUIREMENTS ⌐ 402

DETERMINE THE ABLATION THRESHOLD
PROPERTIES OF EACH MATERIAL ⌐ 404

DETERMINE THE APPROPRIATE LASER
REQUIREMENTS ⌐ 406

STEP 404 IS TO BE REPEATED WITH A
DIFFERENT SELECTION OF MATERIALS
IF THE RESULTS FROM STEPS 402-4-6
ARE UNSUITABLE ⌐ 408

*Figure 4*